Europäisches Patentamt

European Patent Office

Office européen des brevets

(19)

(11) Publication number: 0 228 156
A2

(12) **EUROPEAN PATENT APPLICATION**

(21) Application number: 86307756.6

(22) Date of filing: 08.10.86

(51) Int. Cl.⁴ G01R 31/28 , G06F 11/26

The title of the invention has been amended (Guidelines for Examination in the EPO, A-III, 7.3).

(30) Priority: 07.11.85 US 796047

(43) Date of publication of application:
08.07.87 Bulletin 87/28

(84) Designated Contracting States:
DE FR GB NL

(71) Applicant: CONTROL DATA CORPORATION
8100-34th Avenue South
Minneapolis Minnesota 55440(US)

(72) Inventor: Stoica, Susan
5816 Creek Valley Road South
Edina Minnesota 55434(US)

(74) Representative: Caro, William Egerton et al
J. MILLER & CO. Lincoln House 296-302 High Holborn
London WC1V 7JH(GB)

(54) Test system for VLSI circuits.

(57) A test system for VLSI circuits comprises a VLSI chip having functional inputs (12) and functional outputs (130), circuitry (28) for controlling test operation of the VLSI chip having a test control input (38) and circuitry for storing test data connected to the circuitry (28) for controlling test operation and connected to the functional inputs. A first rank of functional logic elements (16) on the chip connected to the functional inputs (12). Switches (150) selectively connect either the functional inputs (12) or the circuitry (26) for storing test data to the input of the first rank of functional logic elements. A first rank of flip-flops (50) having two data inputs (48,52) and two data outputs (54,58) provide a selectable data path, one of the inputs (52) being connected to the output of the first rank of functional logic elements (16) and the other (48) of the inputs being connected to the inputs of the first rank of functional logic elements. The flip-flops are controlled by the circuitry (28) for controlling test operation. A second rank of functional logic elements (56) on the chip have an input and an output (54,62), the input being connected to one of the first rank of flip-flops (50). There is an output test data storage circuit (32) and switches - (180) for selectively connecting either the output of the second rank of functional logic elements (56) or the second output of the first rank of flip-flops to the functional output (130) of the chip.

Fig. 1

## A TEST SYSTEM FOR VLSI CIRCUITS AND A FLIP-FLOP

This invention relates to test systems for VLSI - (Very Large Scale Integrated) circuit chips, for example, found in digital electronics systems. In particular, although not so restricted, this invention relates to special test and diagnostic circuitry that resides on or is imbedded in a VLSI chip together with the circuitry which performs the specified chip function. This test and diagnostic circuitry may be used for initial testing of the chip or testing at any time during the useful life of the chip and may include testing of the electronic system in which the chip resides. The flexible embedded test system is sometimes known as FITS.

U.S. Patent Specification No. 4,357,703 shows a test system which has switchable gates for controlling internal data flow at input and output of logic, shift registers for serially receiving data and transmitting data in parallel and a test generator and receiver system. In practice, this sytem has been very useful in logic design. However, as VLSI logic gets more complex with an ever increasing number of gates on a chip, design and testing needs to become more sophisticated. The design in U.S. Patent Specification No. 4,357,703 does not provide adequate ability to look backward in the chip logic sequence from the output register to find the source of transient and intermittent faults. Thus, there is a need to provide for improved detection and isolation of error conditions within chip logic circuitry.

U.S. Patent Specification No. 4,244,048 shows a scan design chip testing method which can be implemented both on individual chips and also on a wafer containing a number of chips during fabrication. U.S. Patent Specification No. 4,244,048 shows implementation of scan design technology which reduced to simplest terms refers to the ability of a register or a rank of flip-flops to serially scan data into and out of the rank for testing purposes but which normally conveys data in a parallel fashion from one stage of combinational logic to another stage of combinational logic. A chip having a scan design can allow the entire chip contents or only selected operands to be read in or out. However, with scan design, the entire scan data path must be accessed every time it is used including portions which may not be of interest. All of this serial transfer of a one bit wide data path takes a lot of time.

As logic chips become larger and larger, the difficulty of using a scan design increases because of the number of control signals required and the number of bits contained in all of the flip-flops or register ranks on a large chip. These make the testing or diagnostic overhead sufficiently large that it becomes a problem in itself. For example, a large number of flip-flop bit sequences requires a very substantial data base of test operands and expected results. Similarly, each different chip type or design requires its own special testing and diagnostic sequences. Thus, while a scan design offers some advantages for determining the contents of the registers or flip-flops in a chip, it also has the burden of producing a cumbersome amount of data. Thus, there is a need to provide for a· way of using the benefits of scan design but avoiding unnecessarily large data bases of test operands and for producing a more manageable chip testing routine.

According to one aspect of the present invention there is provided a test system for VLSI circuits characterised by comprising: a VLSI chip having functional inputs and functional outputs; means for controlling test operation of said VLSI chip having a test control input; means for storing test data connected to said means for controlling test operation and connected to said functional inputs; at least a first rank of functional logic means on said chip connected to said functional inputs; means for selectively connecting either said functional inputs or said means for storing test data to the input of said first rank of functional logic means; at least a first rank of flip-flop means having at least two data inputs and two data outputs for providing a selectable data path, one of said inputs connected to the output of said first rank of functional logic means and the other of said inputs connected to the input of said first rank of functional logic means, said flip-flop means being, in operation, controlled by said means for controlling test operation; at least a second rank of functional logic means on said chip having an input and output, said input being connected to one output of said first rank of flip-flop means; output test data storage means; and means for selectably connecting either the output of said second rank of functional logic means or the second output of said first rank of flip-flop means to the functional output of said chip.

According to another aspect of the present invention there is provided test system for VLSI circuits characterised by comprising: a VLSI logic chip having input means and output means; a plurality of separate combinational logic means arranged sequentially in ranks on said chip between said input means and said output means and constituting as whole the desired logic function of the chip; a plurality of flip-flop means arranged in ranks sequentially connected between said ranks of combinational logic means and each having two independent data paths, the first data path being connected from a first input connected with the output of a preceding combinational logic means and the second input being connected to receive the input of a preceding combinational logic means, the first output of said flip-flop means being connected to a succeeding combinational logic means and the second output of said flip-flop means being available for connection to a succeeding rank of flip-flop means which succeed the adjacent rank of combinational logic means; and control means on said chip for controlling each rank of flip-flop means to operate either in a normal operation mode in which the first input is selected to provide a data input to said flip-flop means from a preceding combinational logic means or from a preceding rank of flip-flop means.

According to a further aspect of the present invention there is provided a test system for VLSI circuits characterised by comprising: a VLSI logic chip having input means and output means; a plurality of separate combinational logic means arranged sequentailly in ranks on said chip between said input means and said output means and constituting as a whole the desired logic function of the chip; a plurality of flip-flop means arranged in ranks sequentially connected between said ranks of combinational logic means and each having two independent data paths, the first data path being connected from a first input connected with the output of a preceding combinational logic means and the second input being connected to receive the input of a preceding combinational logic means, said flip-flop means having at least one data output path; and control means on said chip for controlling each rank of flip-flop means to operate either in the normal operation mode in which the first input is selected to provide a data input to said flip-flop means from a preceding combinational logic means or from a preceding rank of flip-flop means.

According to a still further aspect of the present invention there is provided a flip-flop characterised by comprising; first transmission gate means connected in a first input data path; second transmission gate means connected in a second input data path; normal operation gate means for controlling said first and second transmission gate means to control which of said input data paths are provided to an output data path; clock signal control means for controlling the timing of the ouptut of data in said output data path; clock enable input means for controlling the enabling of input data in said first input data path; SET and RESET control means for controlling output data on the output data path to be a predetermined quantity regardless of input data on either of said first or second input data paths; and a further separate isolated data.output path.

The present invention is a system of diagnostic and testing circuitry which is incorporated into a VLSI chip to provide various diagnostic and maintenance testing and verification procedures. A logic chip according to the present invention may be constructed of the necessary input buffers and output buffers for the intended logic function. The logic of the chip consists of various combinational logic elements and flip-flops serially connected in data paths between the input and output buffers.

In addition to the necessary combinational logic and flip-flops on the chip, the necessary elements of an on-chip maintenance system according to the disclosure of U.S. Patent Specification No. 4,357,703 may be incorporated. Those elements consist of a maintenance control register with its associated control input, an input serial to parallel register, an output serial to parallel register which is connected in series, as well as interconnections with the various data paths on the chip. The input register has the necessary connections to provide pseudorandom number generating capabilities to produce test operands internally.

In addition the logic paths have several ranks of flip-flops having special capabilities included. Early in the data path may be a two-to-one multiplex switch which receives both the conventional logic input as well as an input for test data purposes. Normally, this test data input takes data from the last flip-flop in the adjacent logic chain so that all of the logic at the output end of the logic chain can be placed back at the beginning of an adjacent logic chain. The flip-flops used in the logic chains are of a special design having two inputs and two outputs. The conventional input and output sequence is from one combinational logic unit to the succeeding combinational logic unit and consists of the normal data path. The second input comes from the preceding rank of flip-flops bypassed in the combinational logic units in between and the second distinct output goes to the following rank of flip-flops bypassing the succeeding combinational logic inputs.

Thus, the flip-flops by proper gating may bypass combinational logic units under control so that specific combinational logic units within a chip may be isolated from all other combinational logic units and receive special input operands and have those specific output operands gated as outputs for diagnostic purposes. The multiplex switches at the beginning and ending of each logic chain allow for special gating of outputs to inputs for serial writing and reading of special operands into the chip and out of the chip. However, not all of the flip-flops are on the array and need to be of a special design, the actual implementation depends on design requirements. This allows for flexible trade-off of speed versus easier and more extensive testing. The parallel connection of the special flip-flop ranks allows for an easy and fast testing of a specific portion of the VLSI chip.

The invention is illustrated, merely by way of example, in the accompanying drawings, in which:-

Figure 1 is a block diagram of a flexible imbedded test system according to the present invention;

Figure 2 is a schematic diagram of an initialisation sequence for a logic array using a parallel-serial design to show full definition of the contents of all logic chip ranks in a test system according to the present invention;

Figure 3 shows the test system of Figure 1 in a logic analyser sequence mode;

Figure 4 shows the test system of Figure 1 in a chip interconnect test mode;

Figure 5 shows the test system of Figure 1 in a static chip test mode;

Figure 6 shows the test system of Figure 1 in a dynamic signature analysis test mode;

Figure 7 shows the test system of Figure 1 in a design fault detection mode for an error located between two flip-flop ranks;

Figure 8 shows the test system of Figure 1 in a design fault detection mode for an error located between a last flip-flop rank and an output register;

Figure 9 shows the test system of Figure 1 in a design fault detection mode for an error located between an input buffer and a first flip-flop rank;

Figure 10 shows the test system of Figure 1 in a test mode forcing every flip-flop on a chip to a pseudorandom value;

Figure 11 shows the test system of Figure 1 in a test mode forcing every flip-flop on a chip to a predetermined value using input pins;

Figure 12 shows the test system of Figure 1 in a test mode for flip-flop integrity checking;

Figure 13 shows the test system of Figure 1 in a test mode for a serial data shift into a flip-flop and shift out;

Figure 14a is a schematic diagram of a first embodiment of a flip-flop according to the present invention;

Figure 14b is a truth table for the flip-flop of Figure 14a;

Figure 15a is a schematic diagram of another embodiment of a flip-flop according to the present invention;

Figure 15b is a truth table for the flip-flop of Figure 15a;

Figure 16a is a schematic diagram of yet another embodiment of the flip-flop according to the present invention; and

Figure 16b is a truth table for the flip-flop of Figure 16a.

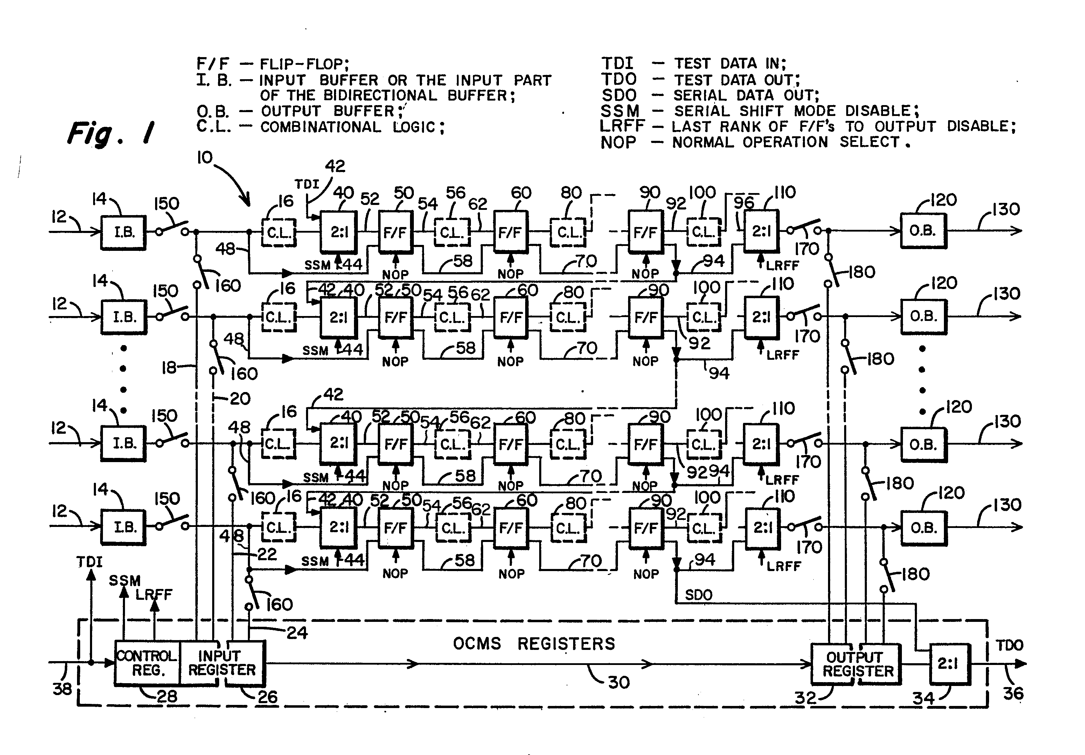

In Figure 1 a flexible embedded test system 10 according to the present invention is shown on a conventional VLSI logic chip. The logic chip has a plurality of input pins 12 each of which is connected with an input buffer 14. The output from each input buffer is switchably connected to a combinational logic unit 16 as required for operation of the intended purpose of the logic chip. In addition, each input buffer has a separate switchable connection 18,20,22,24, etc. to a separate bit of an input register 26 which is part of an on-chip maintenance system as described in U.S. Patent Specification No. 4,357,703. The input register 26 and a control register 28 have the capability of generating pseudorandom numbers and of sending and receiving data in serial or parallel form. The input register 26 is connected by a data path 30 to an output register 32. The contents of the output register 32 are connected through a two-to-one multiplex gate 34 to a test data output pin 36. A test data input pin 38 is connected to the control register 28.

The output of each similar combinational logic unit 16 is connected to a rank of two-to-one multiplex data switches 40. Each multiplex data switch 40 receives a test data input 42 which is from another portion of the logic chip as will be described. Each multiplex data switch 40 has a control input line 44 to control whether the standard data path is used or a serial scan mode data path is used which transfers in the test data.

Each multiplex data switch 40 is connected to a first rank of flip-flops 50 having two distinct inputs and two distinct outputs. The standard mode of operation of the rank of flip-flops is to have the normal operating data from the multiplex data switch 40 connected through a normal input path 52 through the flip-flop to a normal output path 54 to a next combinational logic element 56. Two modes of test data may be implemented, one in which the output data passes through a test data path 58 which bypasses the combinational logic unit 56 and is gated to a test data input of the next rank of flip-flops 60. The other data path is the path 54 which is connected to the combinational logic units 56. The logic output of combinational logic units 56 passes through a conventional logic data path 62 to the flip-flop 60.

Similarly, the rank of flip-flops 60 is connected directly to combinational logic units 80 which in turn are connected to yet another rank of flip-flops 90. Each flip-flop 60 is also connected to a data path 70 directly to the flip-flop 90 respectively.

Thus, the scheme of connection for test purposes is that each flip-flop is connected directly to the succeeding flip-flop so that no logic processing operation occurs in the combinational logic unit and unchanged operands are passed within the chip. However, for normal operation, data is passed through the combinational logic units and the flip-flop rank for the required logic operations.

Finally, each flip-flop 90 is connected directly to a combinational logic unit 100. Each flip-flop 90 is also connected through a bypass data path 94 to a respective two-to-one multiplex switch 110. Each flip-flop 90 has a conventional data path 92 to the combinational logic unit 100 which in turn has a conventional data path 96 output to a two-to-one multiplex switch 110. The bypass data paths 94 between the flip-flops 90 and the multiplex switches 110 also include a data path 42 which is connected back as an input to the first rank of two-to-one multiplex switches 40 for use in the serial scan test mode.

Finally, the outputs of the multiplex switches 110 are switchably connected to a rank of output buffers 120. The output buffers all receive data either from the output register 32 of the maintenance and diagnostic system or from the two-to-one multiplex switches 110. Finally, the output of output buffers 120 is connected to output pins 130 to provide data output for the chip.

Switches 150,160,170,180 are controlled by the control register 28 and form part of the control system of the on-chip maintenance system as shown in U.S. Patent Specification No. 4,357,703. These switches control the data path in normal parallel in and out mode and allow the registers 26,32 to provide serial data shifts.

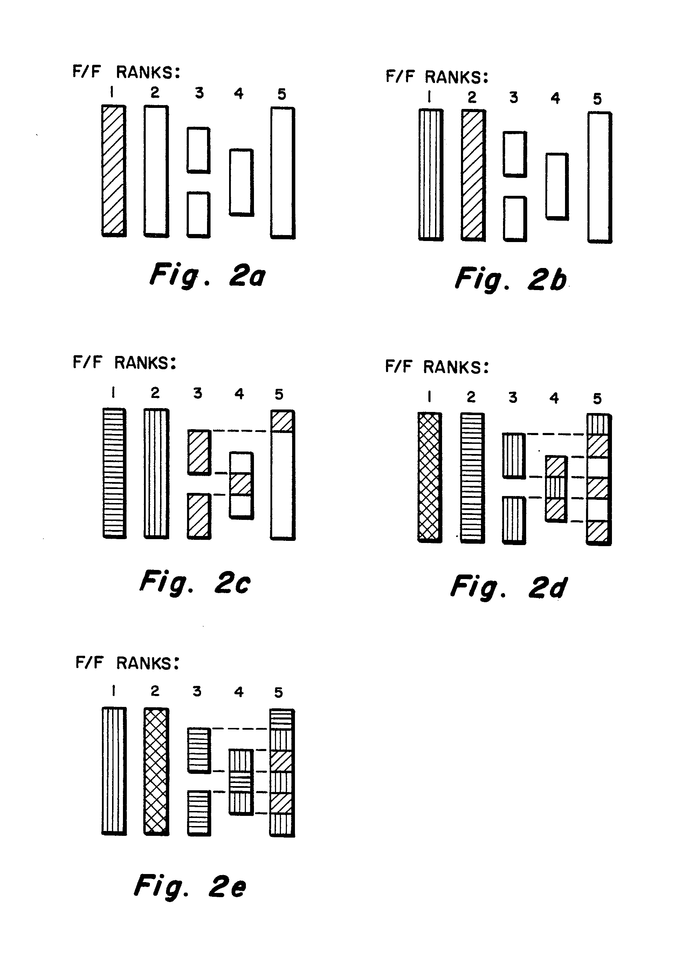

Referring now to Figure 2, an intialisation sequence is shown for an array having five flip-flop ranks and in which there are different numbers of flip-flops in the different ranks. Also, some flip-flop ranks skip one or two possible logic levels so that data passes more rapidly in one chain than another. Note for example that some flip-flops in rank 2 are connected directly to ranks 4 or 5. The different cross-hatch patterns show a level of logic as it is clocked through the flip-flops. This sequence shows that, even if some of the flip-flop ranks have fewer flip-flops than other ranks, the content of every flip-flop on the chip is defined after a number of clocks equal the number of flip-flop ranks.

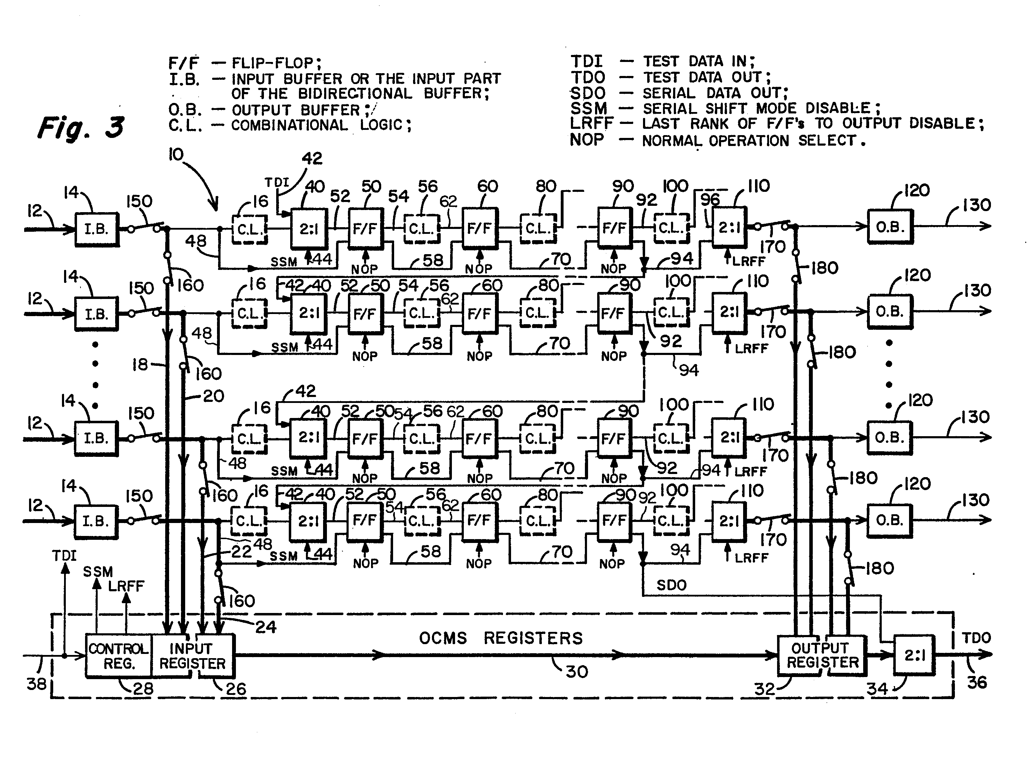

Figure 3 shows a logic analyser sequence which is similar to the standard operation of the maintenance and test system shown in U.S. Patent Specification No. 4,357,703 in which input data is provided through the input pins 12 and input buffers 14 and connected into the input register 26. The input register 26 is connected through the data path 30 to the output register 32 as well as to the input of the rank of output buffers 120. The output buffers 120 are connected to the output register 32 and hence to the output pin 36 to ensure that the input/output value of the chip functions can be monitored during normal chip activity. In this mode, SSM (Serial Shift Mode disable), NOP (Normal OPeration select) and LRFF (Last Rank of Flip-Flop to output disable) values are set to 1.

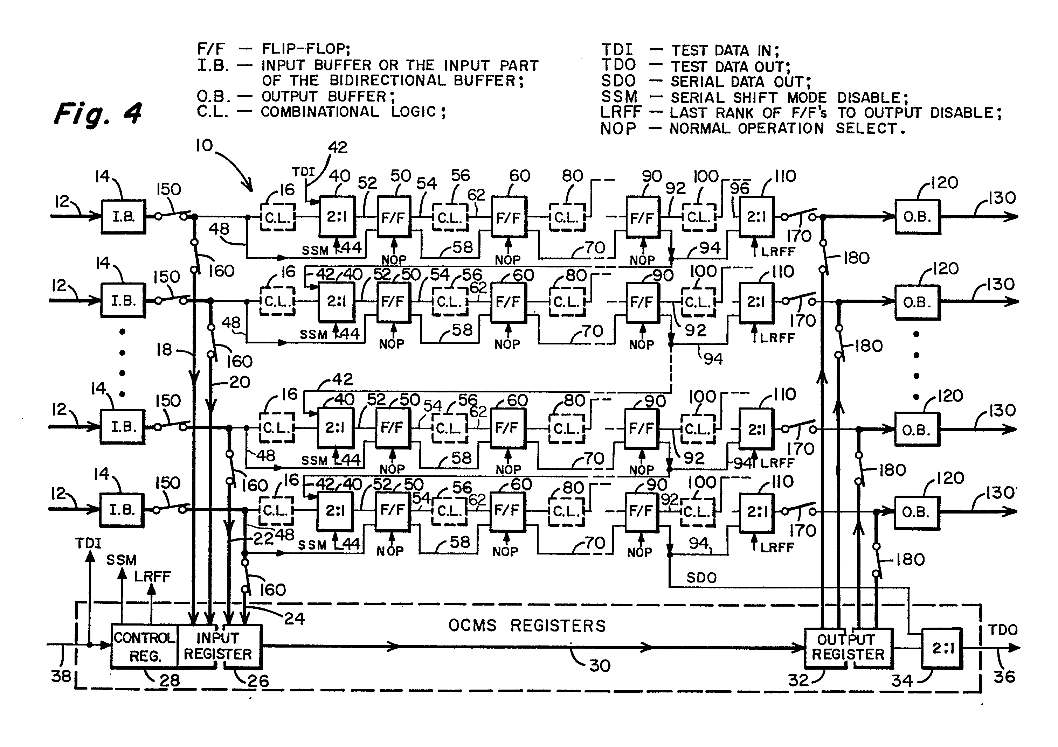

Figure 4 shows a basic chip interconnect test sequence, the SSM, NOP and LRFF values are set to 1.

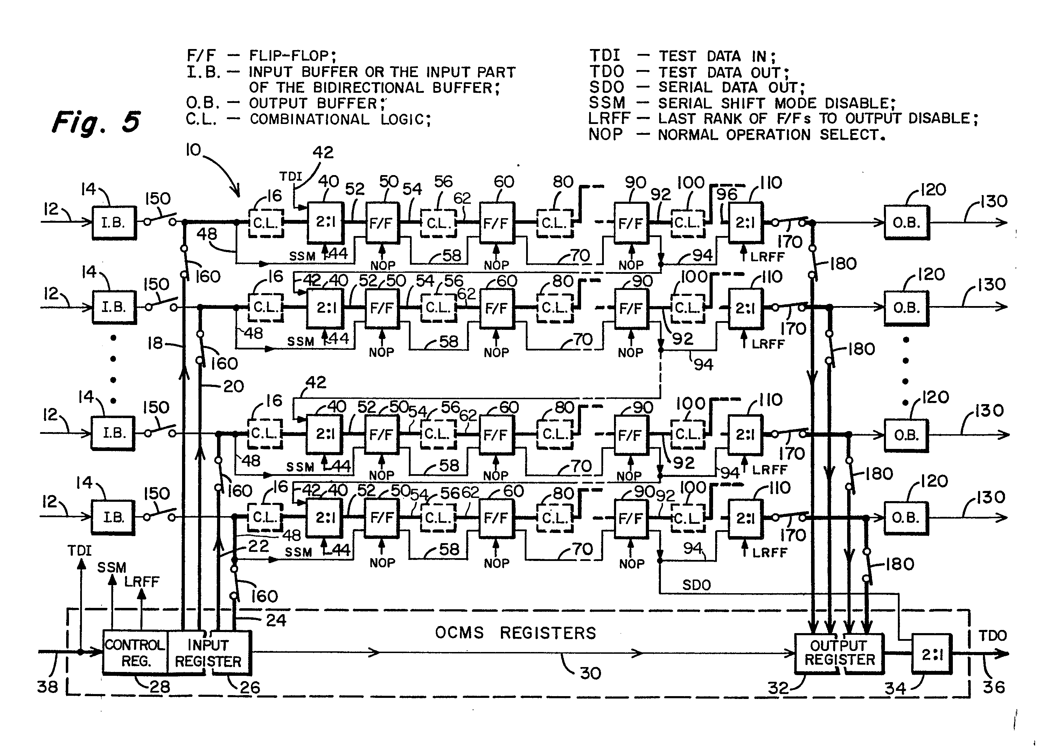

Figure 5 shows a static chip test in which input data is provided to the input register 26 and passed through all of the combinational logic and flip-flop ranks of the chip in normal operating mode and connected through the output register 32 to the output pin 36. This test sequence determines if all the logic in the chip is operating in a normal fashion independently of input and output pins and input and output buffers and is thus a pure test of the logic in the chip separate and apart from input and output transients. Again, this function is similar to that shown in U.S. Patent Specification No. 4,357,703.

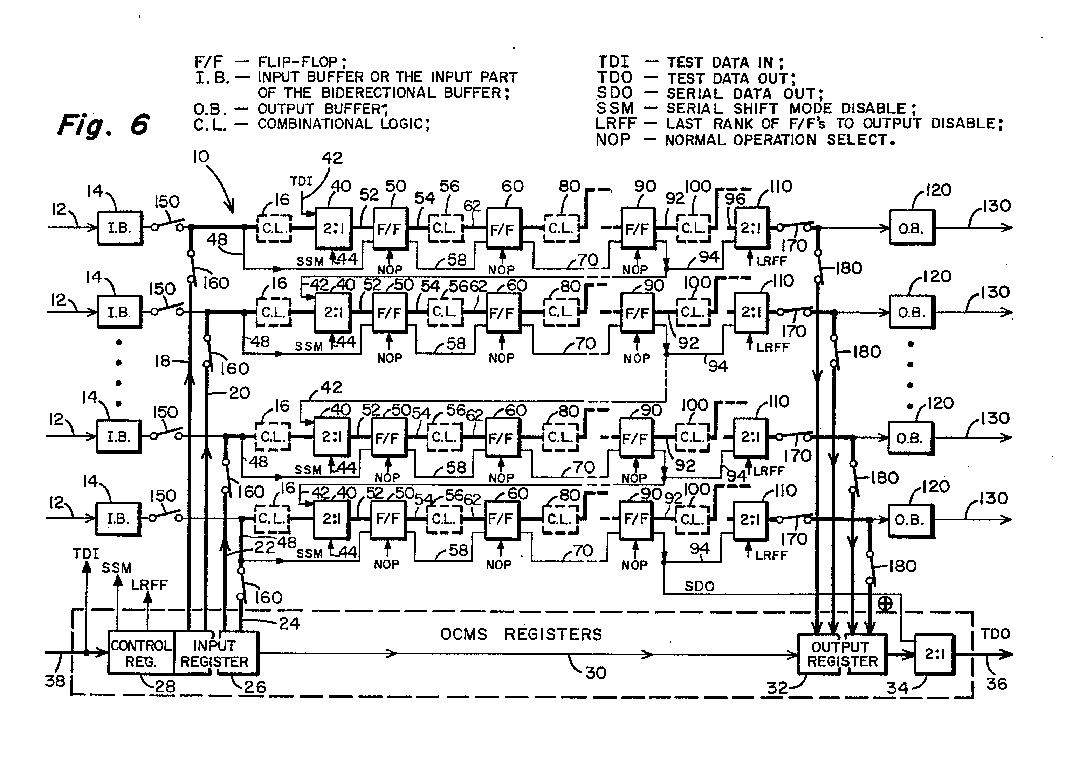

Figure 6 shows a similar test to that shown in Figure 5. The input register 26 produces a pseudorandom input data system and the output register 32 is checksumming the results. This sequence is a dynamic signature analysis function.

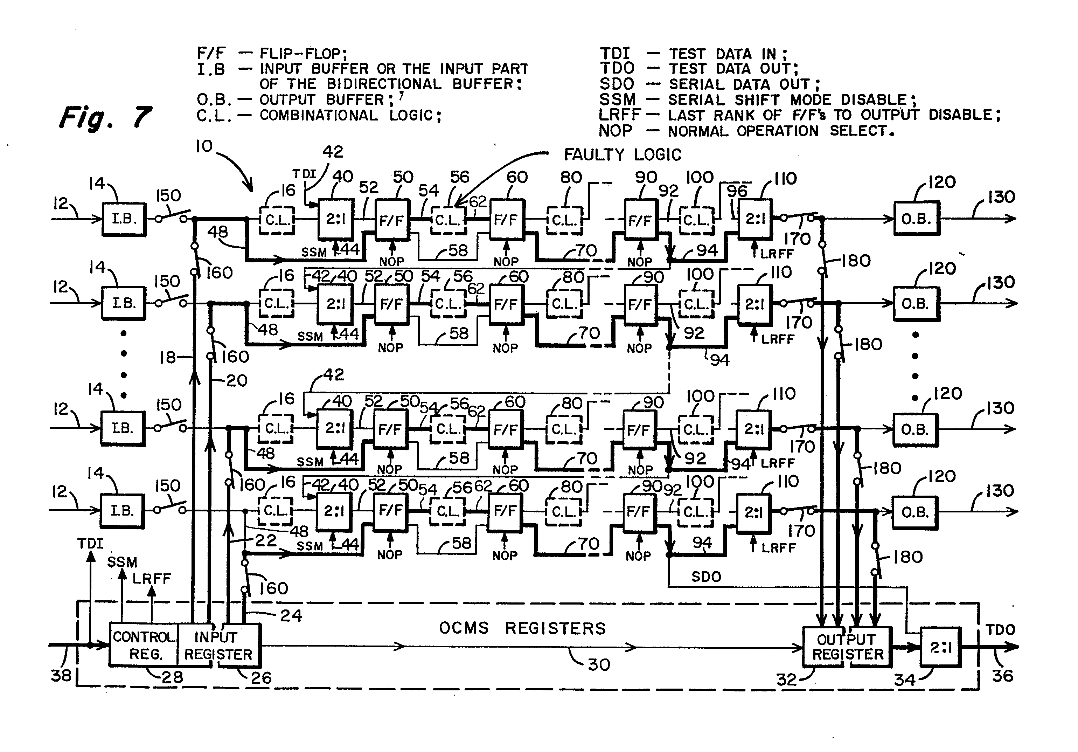

Figure 7 shows a test in which the test data input register 26 provides data to the conventional logic paths in the chip. However, the rank of flip-flops 50 is adjusted to take inputs from the input path 48 thereby bypassing the rank of combinational logic units 16. The output of the rank of flip-flops 44 is connected to the rank of combinational logic units 56 which is to be tested to determine if it is faulty. The output flip-flop rank from the rank of combinational logic units 56 is the rank of flip-flops 60 which is selected to pass its output down the data path through other ranks of flip-flops such as the rank of flip-flops 90, bypassing other ranks of combinational logic units such as the rank of combinational logic units 80 so that the output is connected directly through the rank of multiplex switches 110 into the output register 32. Thus, the input pins, the input buffers, the output buffers and output pins are isolated in this test. By proper selection of the gating of the ranks of flip-flops 50,60,90 and the multiplex switches 40,110, the data passes only through the rank of combinational logic units 56. The SSM value is 1. The NOP value is set at 0 initially, then 1 for one clock period, then 0 for the rest of the test data. The LRFF value is 0.

Thus, a pure test of the rank of combinational logic units 50 is provided between data flowing from the input register 26 to the output register 32 and through the output pin 36.

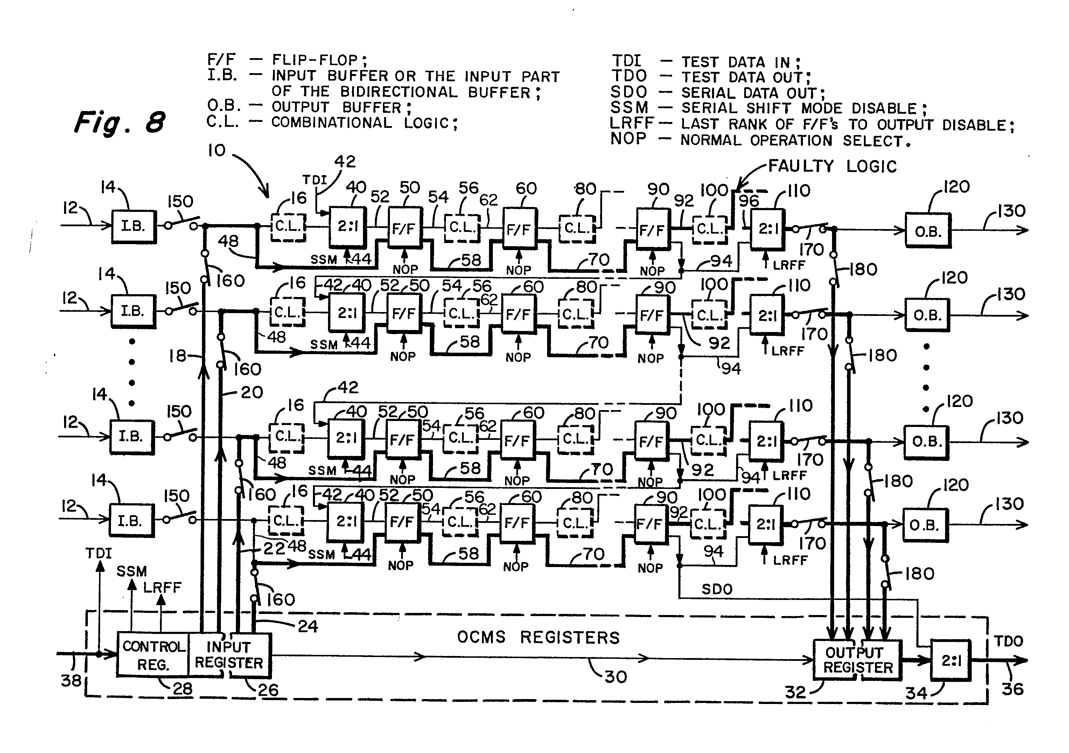

Figure 8 shows a similar test sequence where the presumed faulty logic rank is the rank of combinational logic units 100 and the data bypasses the other ranks of combinational logic units so that the only data operation is performed in the rank of combinational units 100.

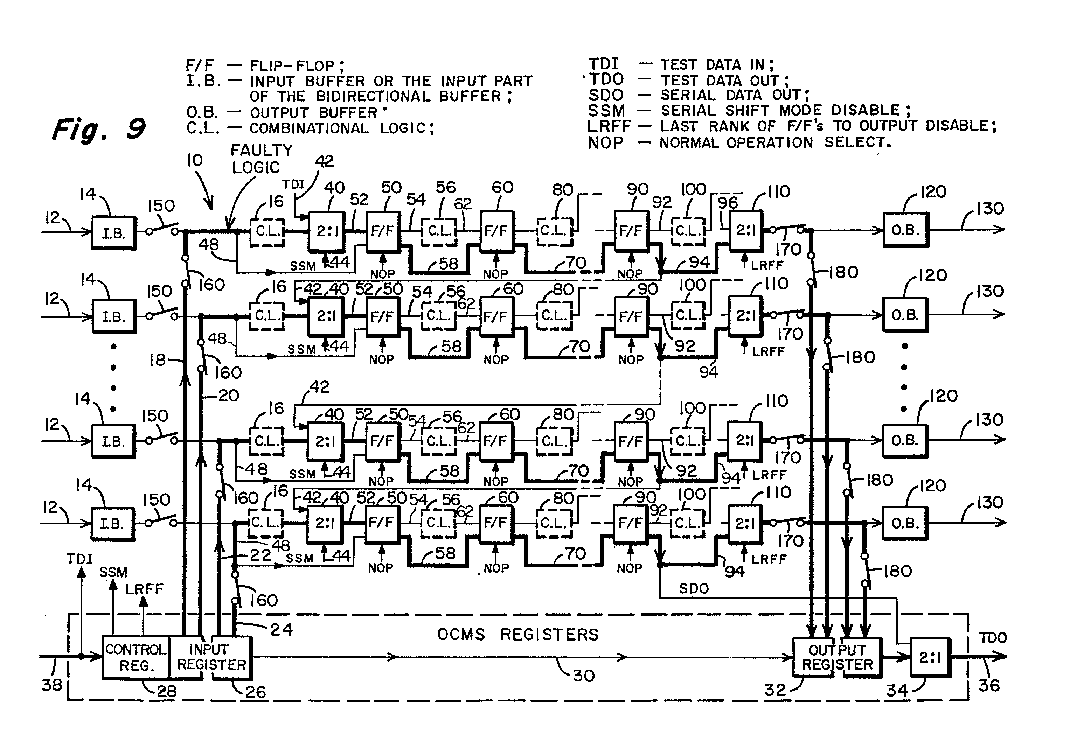

Following a similar pattern, Figure 9 shows a test in which the only rank of combinational logic units which has data passing through it is the rank of combinational logic units 16 and the flip-flops 50,60,90 and multiplex switches 40,110 are set to connect data from the input register 26 to the output register 32 so as to bypass all other ranks of combinational logic units. The SSM value is 1 and the LRFF value is 0. The NOP value is set to 1 for one clock period and then set to 0 for the rest of the test.

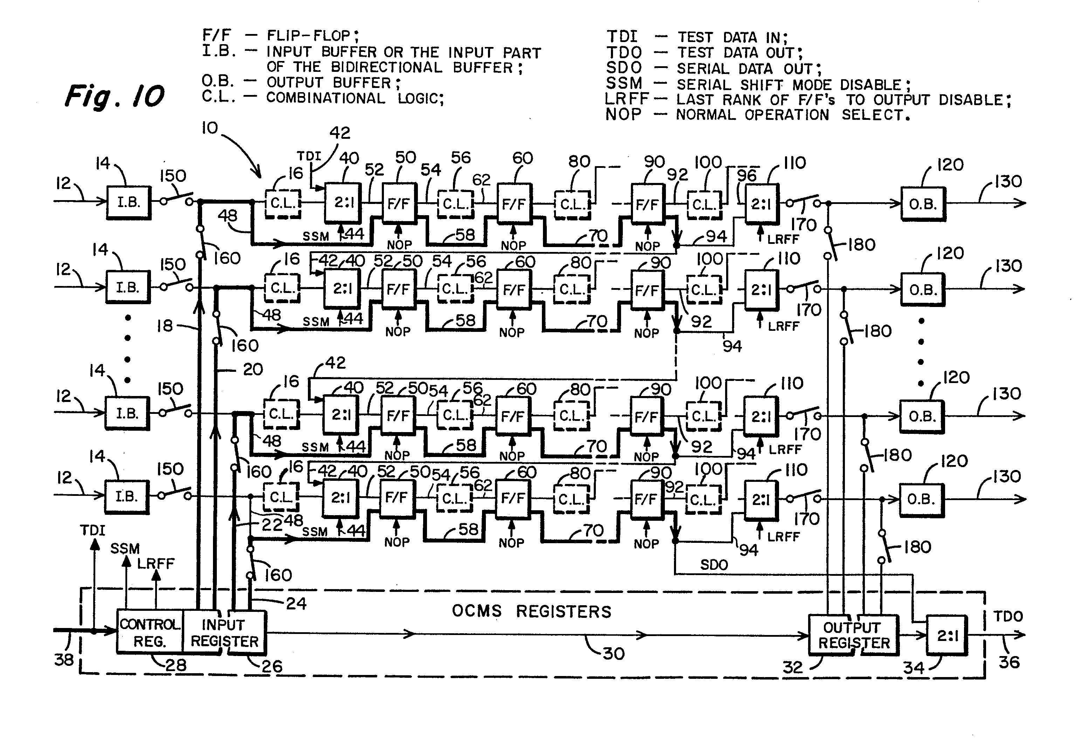

Figure 10 shows the case in which all combinational logic units are bypassed so that test data from the input register 26 can be passed sequentially to all ranks of flip-flops 50,60,90 to set the condition of all flip-flops to a predetermined condition. The SSM value is 1 while the NOP value is 0.

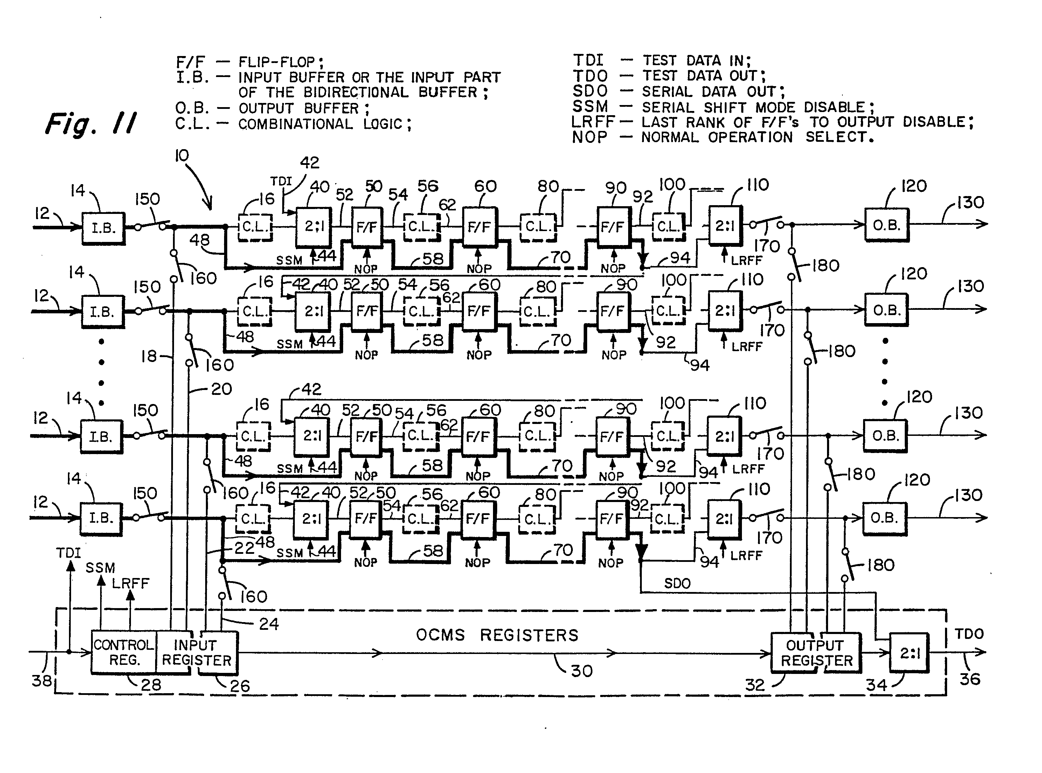

Figure 11 shows the same condition of forcing every flip-flop on a chip to be a predetermined value by using the conventional input pins 12 rather than the input register 26 to provide the data path.

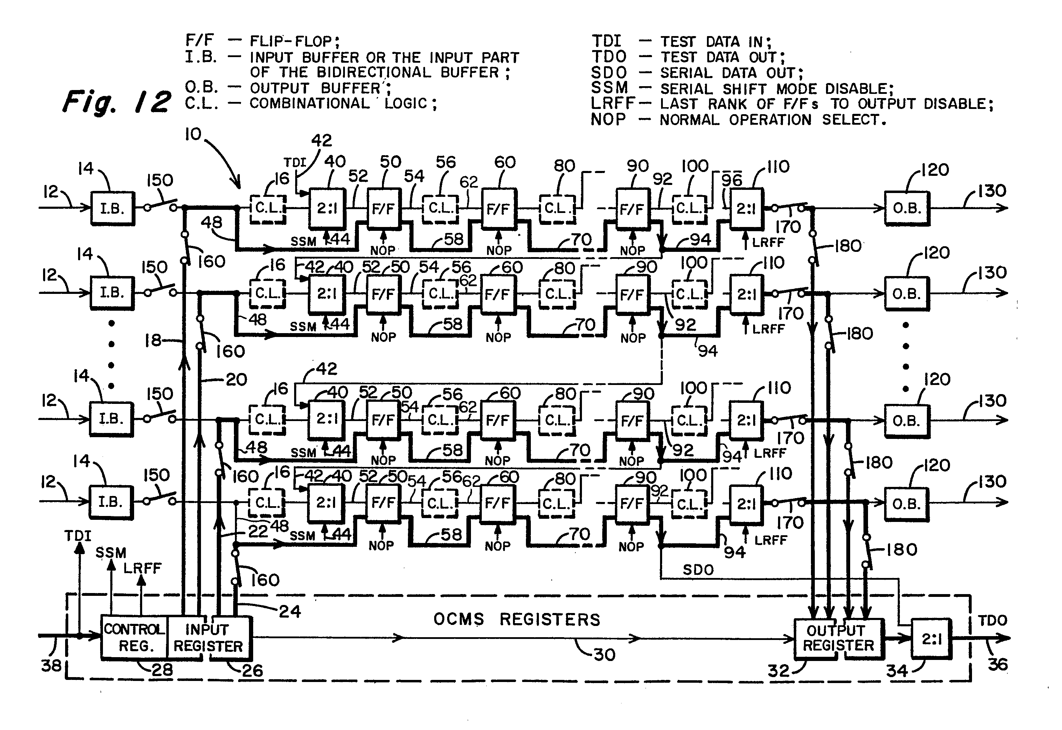

Figure 12 shows the situation in which the flip-flops only are tested for integrity and in which no combinational logic units are employed on the chip so that all data flows only through the flip-flops on the chip and not through any of the combinational logic units or multiplex switches. The SSM value is 1 while the NOP and LRFF values are 0.

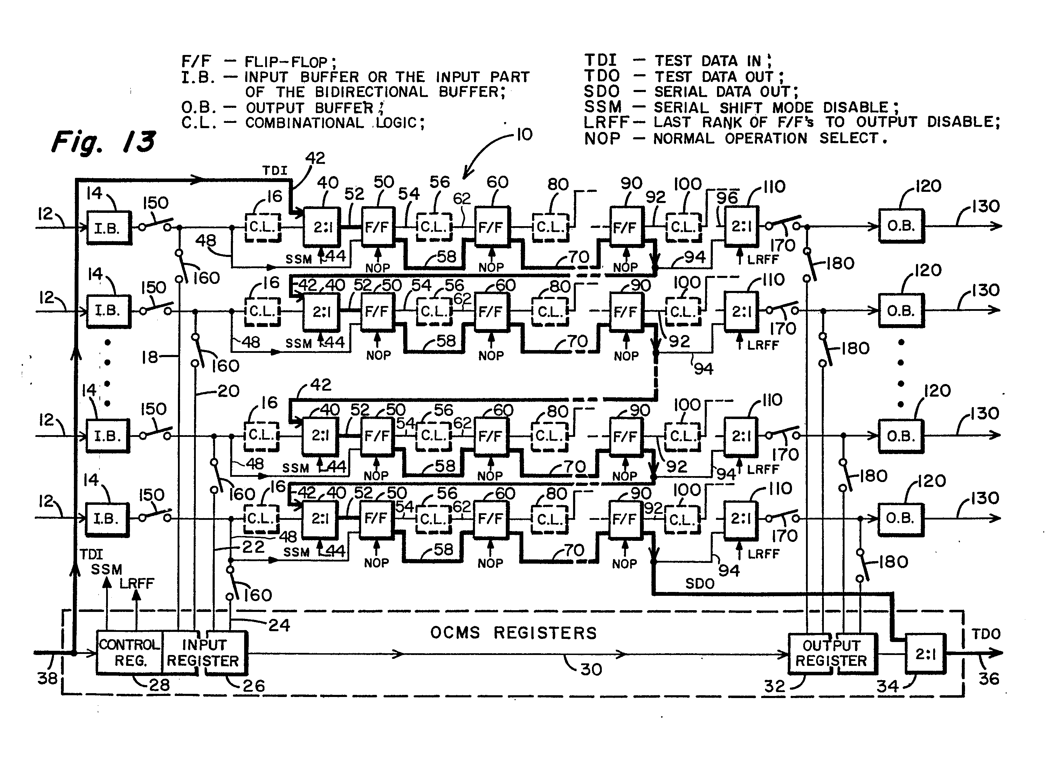

Finally, Figure 13 shows the situation in which the multiplex switches 40,110 are set for a scan pattern function with all of the flip-flops so that data may be scanned serially through the entire chip starting from input pin 38 through the first multiplex switches 40 sequentially through all of the flip-flops 50,60,90 and then sequentially through all of the flip-flops and out through the test data output pin. The SSM and NOP values are set to 0.

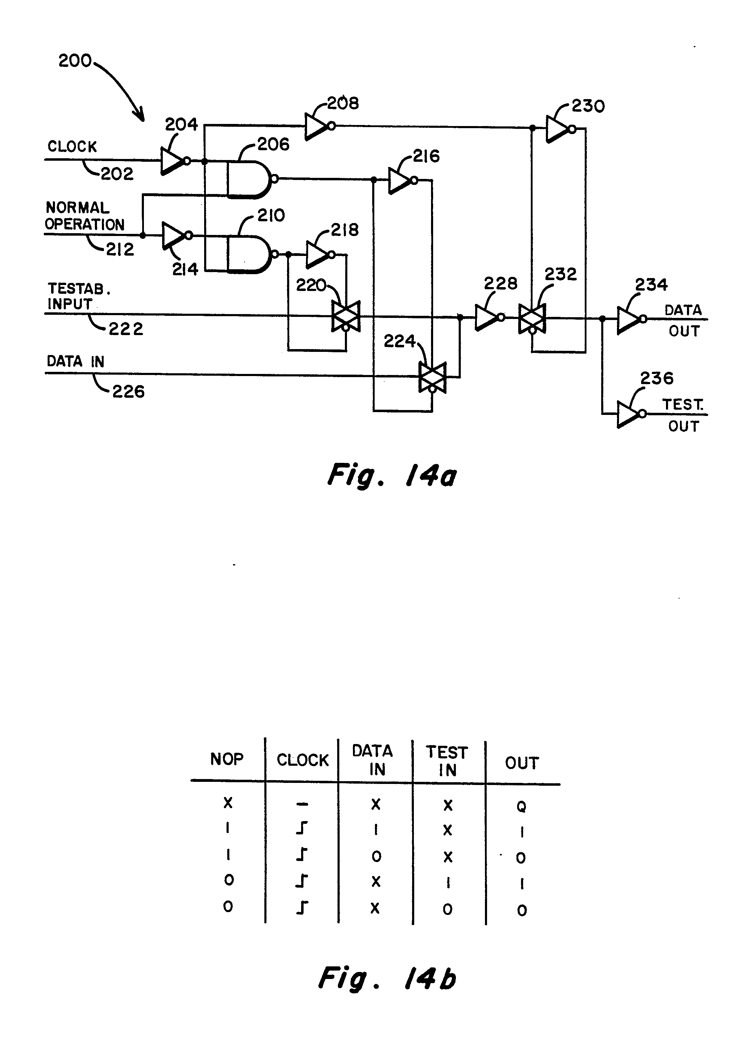

Figures 14a, 15a and 16a show flip-flops according to the present invention for a test system according to the present invention having an increased degree of complexity and controllability depending on the needs of the designer. One of the advantages of the test system is that it may be used in conjunction with any one of a number of different types of flip-flops in the various ranks, or it may be used with several different types of flip-flops in the different ranks.

Referring now to Figure 14a, a flip-flop 200 has a clock input 202 to an inverter 204 which is connected as one of the inputs to an AND gate 206. The output of the inverter 204 is also connected to an inverter 208 and an AND gate 210. The flip-flop has the normal operation (NOP) input 212 which is connected with an inverter 214 and provides a second input to the AND gate 206. The output of the inverter 214 provides a second input to the AND gate 210. The outputs of the AND gates 206,210, are both inverted and connected to inverting drivers 216,218, respectively. Drivers 216,218 each drive transmission gates of a standard P-N junction type, also referred to as T-gates. T-gates are specific to CMOS technology but this invention is not limited to CMOS technology and may be implemented in other ways. CMOS technology is a convenient reference point for explaining this embodiment of the present invention.

The driver 218 controls a T-gate 220 which is connected to a testability input 222 to the flip-flop. The driver 216 controls a T-gate 224 which is connected to a data input 226 to the flip-flop. The outputs of the T-gates 220,224 are connected to the input to an inverter 228. The design of the flip-flop is such that the T-gates 220,224 will not be on at the same time. The output of the inverter 208 is connected to an inverting driver 230 which drives a T-gate 232 connected to the output of the inverter 228. The output of the T-gate 232 is connected to inverters 234,236 to provide isolation at the output. The inverter 234 provides the data output of the flip-flop while the inverter 236 provides the testability output of the flip-flop.

Figure 14b provides a truth table for the flip-flop of Figure 14a. The normal operation input is shown together with the clock, data in and testability input as related to the output. As can be seen from the schematic diagram, both the data output and the testability output are the same. In the truth table, the symbol "X" relates to a "does not matter condition" and the symbol "Q" refers to a "remains in the same condition as before" output. The "Q" output means that previous binary 0 output remains as binary 0, and a previous binary 1 output remains at binary 1.

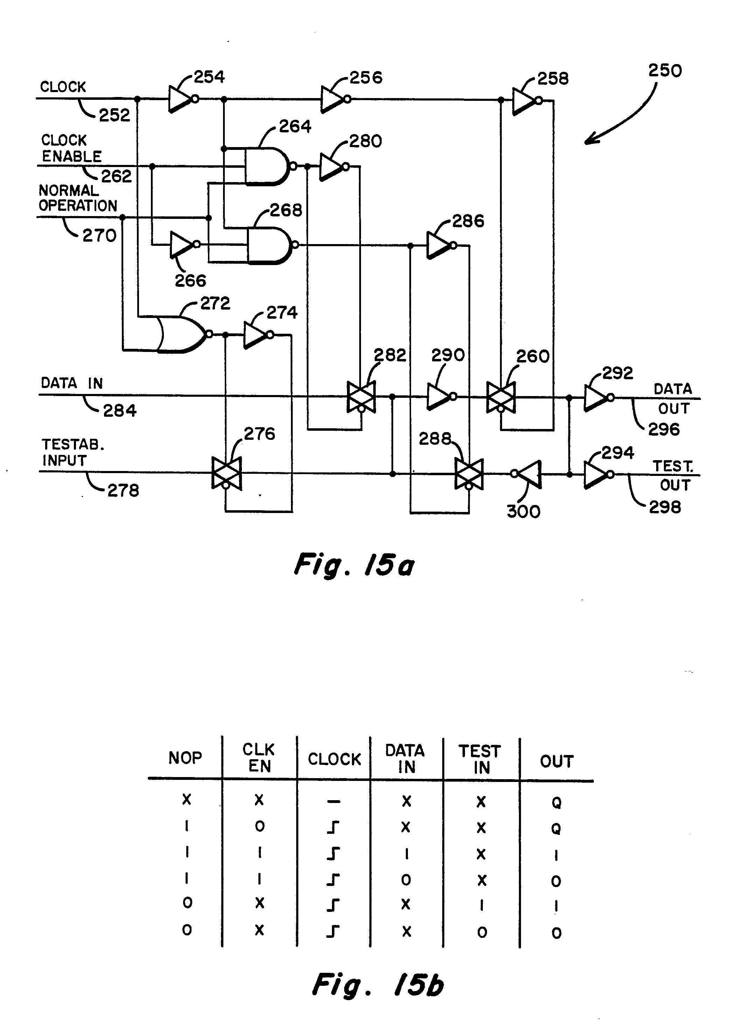

Referring now to Figure 15a, a more complicated flip-flop 250 according to the present invention is shown which has an additional clock enable input not shown in the flip-flop of Figure 14a. The flip-flop 250 has a clock input 252 connected to an inverter 254 the output of which is connected to an inverter 256. The output of the inverter 256 is connected with an inverting driver 258 which controls a T-gate 260. The clock enable input 262 is connected as one input to an AND gate 264 and to an inverter 266. The output of the inverter 266 provides one input to an AND gate 268. The output of the inverter 254 provides a second input to both AND gates 264,268. A normal operation input 270 is connected to provide a third input to both AND gates 264,268. The normal operation input is also connected as one input to an OR gate 272. The second input to the OR gate 272 is the clock input 252. The OR gate output is inverted and controls an inverting driver 274 which drives a T-gate 276. The T-gate 276 is in a testability input line 278. The output of the AND gate 264 controls an inverting driver 280 which controls a T-gate 282 which is in a data input line 284. The output of the AND gate 268 controls an inverting driver 286 which drives a T-gate 288. The input to the T-gate 288 is a wired connection of the outputs of the T-gate 282,276. The output of the T-gate 282 is connected to an inverter 290, the output of which is connected to the T-gate 260. The output of the T-gate 260 is connected to inverters 292,294 to provide isolation for a data output 296 and a testability output 298. In addition, this output signal from the T-gate 260 is also connected back through an inverter 300 through the T-gate 288 to provide an additional wired input for feedback to the inverter 290.

Figure 15b is a truth table for the flip-flop of Figure 15a showing the effect that the various states of the various inputs has on the output of the flip-flop. Again, the testability output and the data output are the same.

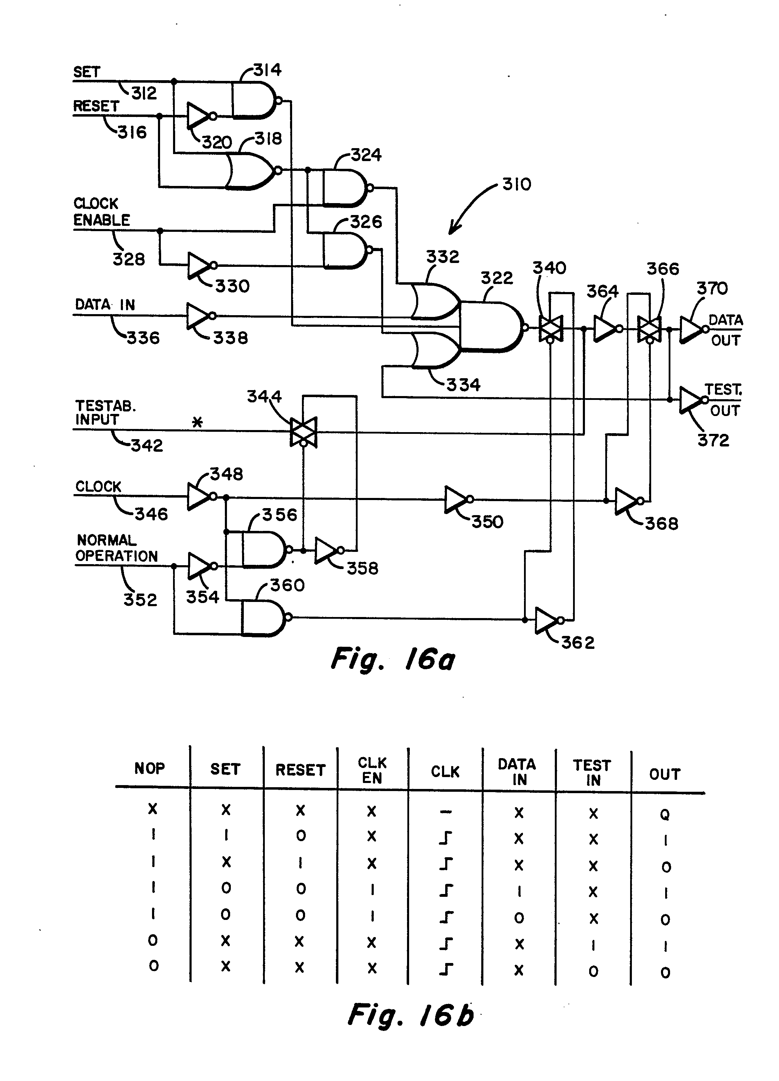

Referring now to Figure 16a another flip-flop 310 according to the present invention is shown. This flip-flop is more complex than the flip-flop 250 of Figure 15a in that it has a SET input 312 connected to an AND gate 314 and a RESET input 316 connected with an OR gate 318 as additional inputs. The SET input 312 also provides a second input to the OR gate 318. The RESET input 316 is connected through an inverter 320 to provide a second input to the AND gate 314. The output of the AND gate 314 is inverted and connected as one input of an AND gate 322. The output of the OR gate 318 is connected and provided as one input to AND gate 324,326. A clock enable input 328 is connected as the second input to the AND gate 324. The clock enable input 328 is connected through an inverter 330 to provide the second input to the AND gate 326. The output of the AND gate 324 is inverted and connected as one input to an OR gate 332. The output of the OR gate 332 is a second input to the AND gate 322. The output of the AND gate 326 is inverted and connected as one input to an OR gate 334. The output of the OR gate 334 is a third input to the AND gate 322. A data input connection 336 goes through an inverter 338 and provides a second input to the OR gate 332. The output of the AND gate 322 is inverted and connected to a T-gate 340.

A testability input 342 is connected to a T-gate 344. A clock input 346 is connected through an inverter 348 to an inverter 350. A normal operation (NOP) input 352 is connected through an inverter 354 to an AND gate 356. One output of the inverter 348 provides the second input to the AND gate 356. The output of the AND gate 356 is connected to an inverter driver 358 which controls the T-gate 344. In addition, the normal operation input (NOP) 352 is connected to an AND gate 360. The AND gate 360 receives a second input from the inverter 348. The output of the AND gate 360 is inverted and controls an inverter driver 362 which drives the T-gate 340.

The output of the T-gate 344 and the output of the T-gate 340 are combined as inputs to an inverter 364. The output of the inverter 364 is connected as an input to a T-gate 366. The T-gate 366 is controlled by the output of the inverter 350 which has its output connected to an inverter driver 368. The output of the T-gate 366 is connected to inverters 370,372 which provide the outputs of the flip-flop. The output of the T-gate 366 is also provided as the second input to the OR gate 334.

Figure 16b shows a truth table for the flip-flop of Figure 16a. As can be seen from the truth table, all the control features of the flip-flops shown in Figures 14a .and 15a are present, but with the addition that the use of the SET and RESET inputs to the flip-flop can be used to force the output to a 0 or a 1, as desired.

The present invention has numerous advantages. One particular area of advantage of the present invention is the ease and convenience with which test operands may be loaded into a chip for testing of combinational logic, and the ease with which specific combinational logic units may be isolated for testing. Because loading of test operands into a particular area of a chip may be accomplished in parallel by direct gating through testability gates on flip-flops skipping other combinational logic units, test routines may be run far more quickly and efficiently than previously. In particular, the long time period for loading and unloading required for typical scan designs is avoided.

Similarly, specific combinational logic elements within a chip may be tested and isolated from preceding and succeeding combinational logic units in a way either not previously possible or possible only with cumbersome techniques and a complex scan design. The various advantages of the scan design are primarily developed in connection with the flexibility that this design provides for test routines of various sorts. In addition to the flexibility of test routines that may be adopted, this design is also flexible in that several different types of flip-flops can be placed on a logic chip so as to avoid the restrictions of some previous test designs which required a single type of flip-flop in all locations in a logic chip.

This test system can test with the same ease a restricted amount of combinational logic if it is before the first special flip-flop rank, between two flip-flop ranks or between the last flip-flop rank and the output. Any of these sequences will not require the initialisation of every flip-flop on the array to a predetermined value, which is very time consuming and requires a larger data base.

**Claims**

1. A test system for VLSI circuits characterised by comprising: a VLSI chip having functional inputs (12) and functional outputs (130); means (28) for controlling test operation of said VLSI chip having a test control input (38); means (26) for storing test data connected to said means (28) for controlling test operation and connected to said functional inputs; at least a first rank of functional logic means (16) on said chip connected to said functional inputs (12); means (150) for selectively connecting either said functional inputs (12) or said means - (26) for storing test data to the input of said first rank of functional logic means; at least a first rank of flip-flop means (50) having at least two data inputs (48,52) and two data outputs (54,58) for providing a selectable data path, one of said inputs (52) connected to the output of said first rank of functional logic means (16) and the other (48) of said inputs connected to the input of said first rank of functional logic means, said flip-flop means being, in operation, controlled by said means (28) for controlling test operation; at least a second rank of functional logic means (56) on said chip having an input and output (54,62), said input being connected to one output of said first rank of flip-flop means (50); output test data storage means (32); and means (180) for selectably connecting either the output of said second rank of functional logic means (56) or the second output of said first rank of flip-flop means to the functional output (130) of said chip.

2. A test system for VLSI circuits characterised by comprising: a VLSI logic chip having input means and output means (12,130), a plurality of separate combinational logic means (16,56,80,100) arranged sequentially in ranks on said chip between said input means (12) and said output means (130) and constituting as a whole the desired logic function of the chip; a plurality of flip-flop means (50,60,90) arranged in ranks sequentially connected between said ranks of combinational logic means and each having two independent data paths (48,52;58,62), the first data path being connected from a first input connected with the output of a preceding combinational logic means and the second input being connected to receive the input of a preceding combinational logic means, the first output of said flip-flop means being connected to a succeeding combinational logic means and the second output of said flip-flop means being available for connection to a succeeding rank of flip-flop means which succeed the adjacent rank of combinational logic means; and control means (28) on said chip for controlling each rank of flip-flop means to operate either in a normal operation mode in which the first input is selected to provide a data input to said flip-flop means from a preceding combinational logic means or from a preceding rank of flip-flop means.

3. A test system for VLSI circuits characterised by comprising: a VLSI logic chip having input means (12) and output means (130); a plurality of separate combinational logic means (16,56,80,100) arranged sequentailly in ranks on said chip between said input means (12) and said output means (130) and constituting as a whole the desired logic function of the chip; a plurality of flip-flop means (50,60,90) arranged in ranks sequentially connected between said ranks of combinational logic means and each having two independent data paths (48,52; 58,62), the first data path being connected from a first input connected with the output of a preceding combinational logic means and the second input being connected to receive the input of a preceding combinational logic means, said flip-flop means having at least one data output path; and control means (28) on said chip for controlling each rank of flip-flop means to operate either in the normal operation mode in which the first input is selected to provide a data input to said flip-flop means from a preceding combinational logic means or from a preceding rank of flip-flop means.

4. A test system as claimed in any preceding claim characterised by a plurality of ranks of logic means and ranks of flip-flop means connected in sequence so that each of said flip-flop means may have a selected input which bypasses at least one of said ranks of logic means.

5. A test system as claimed in any preceding claim characterised in that at least some of said ranks of flip-flop means have a fewer number of flip-flop means than others, selectable inputs of some of said flip-flop means, in operation, selecting inputs from different ranks of logic means to bypass said ranks of flip-flop means having fewer flip-flop means.

6. A test system as claimed in any preceding claim characterised in that more than one type ot flip-flop means is used in different ranks of flip-flop means.

7. A test system as claimed in any preceding claim characterised in that said the or each rank of flip-flop means comprises flip-flops each having: first transmission gate means (340) connected in a first data input path (336); second transmission gate means (344) connected in a second input data path (342); normal operation gate means (356,360) for controlling said first and second transmission gate means (340,344) to control which of said input data paths are provided to an output data path - (370); clock signal control means (366) for controlling the timing of the output of data in said output data path; clock enable input means - (322,324,326,332,334) for controlling the enabling of input data in said first input data path; SET and RESET control means (314,318) for controlling output data on the output data path to be a predetermined quantity regardless of input data on either of said first or second input data paths; and a further separate isolated data output path (372).

8. A test system as claimed in claim 2 or 3 characterised by a control register (28) having a test data input and an input register means (26) for serially receiving test data, input operands and control signals, means (150) for switchably connecting said input register means in parallel to the input of said combinational logic means; output register means (32) connected to receive the outputs of the last in sequence of the ranks of combinational logic means on said chip and having test data output means (36) for transmitting said data from said chip in serial fashion.

9. A flip-flop characterised by comprising: first transmission gate means (340) connected in a first input data path (336); second transmission gate means (344) connected in a second input data path (342); normal operation gate means (356,360) for controlling said first and second transmission gate means (340,344) to control which of said input data paths are provided to an output data path (370); clock signal control means (366) for controlling the timing of the output of data in said output data path; clock enable input means (322,324,326, 332,334) for controlling the enabling of input data in said first input data path; SET and RESET control means (314,318) for controlling output data on the output data path to be a predetermined quantity regardless of input data on either of said first or second input data paths; and a further separate isolated data output path (372).

**Fig. 1**

F/F — FLIP-FLOP;
I.B. — INPUT BUFFER OR THE INPUT PART OF THE BIDIRECTIONAL BUFFER;
O.B. — OUTPUT BUFFER;
C.L. — COMBINATIONAL LOGIC;

TDI — TEST DATA IN;
TDO — TEST DATA OUT;
SDO — SERIAL DATA OUT;
SSM — SERIAL SHIFT MODE DISABLE;
LRFF — LAST RANK OF F/F's TO OUTPUT DISABLE;
NOP — NORMAL OPERATION SELECT.

OCMS REGISTERS

Fig. 2a

Fig. 2b

Fig. 2c

Fig. 2d

Fig. 2e

**Fig. 3**

F/F — FLIP-FLOP;
I.B. — INPUT BUFFER OR THE INPUT PART
OF THE BIDIRECTIONAL BUFFER;
O.B. — OUTPUT BUFFER;
C.L. — COMBINATIONAL LOGIC;

TDI — TEST DATA IN;
TDO — TEST DATA OUT;
SDO — SERIAL DATA OUT;
SSM — SERIAL SHIFT MODE DISABLE;
LRFF — LAST RANK OF F/F's TO OUTPUT DISABLE;
NOP — NORMAL OPERATION SELECT.

OCMS REGISTERS

0 228 156

# Fig. 4

F/F — FLIP-FLOP;
I.B. — INPUT BUFFER OR THE INPUT PART OF THE BIDIRECTIONAL BUFFER;
O.B. — OUTPUT BUFFER;
C.L. — COMBINATIONAL LOGIC;

TDI — TEST DATA IN;
TDO — TEST DATA OUT;
SDO — SERIAL DATA OUT;
SSM — SERIAL SHIFT MODE DISABLE;
LRFF — LAST RANK OF F/F's TO OUTPUT DISABLE;
NOP — NORMAL OPERATION SELECT.

0 228 156

Fig. 5

F/F — FLIP-FLOP;
I.B. — INPUT BUFFER OR THE INPUT PART
OF THE BIDIRECTIONAL BUFFER;
O.B. — OUTPUT BUFFER;
C.L. — COMBINATIONAL LOGIC;

TDI — TEST DATA IN;
TDO — TEST DATA OUT;
SDO — SERIAL DATA OUT;
SSM — SERIAL SHIFT MODE DISABLE;
LRFF — LAST RANK OF F/Fs TO OUTPUT DISABLE;
NOP — NORMAL OPERATION SELECT.

OCMS REGISTERS

CONTROL REG.
INPUT REGISTER
OUTPUT REGISTER

0 228 156

*Fig. 6*

F/F — FLIP-FLOP;
I.B. — INPUT BUFFER OR THE INPUT PART
    OF THE BIDERECTIONAL BUFFER;
O.B. — OUTPUT BUFFER;
C.L. — COMBINATIONAL LOGIC;

TDI — TEST DATA IN;
TDO — TEST DATA OUT;
SDO — SERIAL DATA OUT;
SSM — SERIAL SHIFT MODE DISABLE;
LRFF — LAST RANK OF F/F's TO OUTPUT DISABLE;
NOP — NORMAL OPERATION SELECT.

OCMS REGISTERS

Fig. 7

F/F — FLIP-FLOP;
I.B — INPUT BUFFER OR THE INPUT PART
        OF THE BIDIRECTIONAL BUFFER;
O.B. — OUTPUT BUFFER;
C.L. — COMBINATIONAL LOGIC;

TDI — TEST DATA IN;
TDO — TEST DATA OUT;
SDO — SERIAL DATA OUT;
SSM — SERIAL SHIFT MODE DISABLE;
LRFF — LAST RANK OF F/F's TO OUTPUT DISABLE;
NOP — NORMAL OPERATION SELECT.

0 228 156

Fig. 8

F/F — FLIP-FLOP;
I.B. — INPUT BUFFER OR THE INPUT PART
OF THE BIDIRECTIONAL BUFFER;
O.B. — OUTPUT BUFFER;
C.L. — COMBINATIONAL LOGIC;

TDI — TEST DATA IN;
TDO — TEST DATA OUT;
SDO — SERIAL DATA OUT;
SSM — SERIAL SHIFT MODE DISABLE;
LRFF — LAST RANK OF F/F's TO OUTPUT DISABLE;
NOP — NORMAL OPERATION SELECT.

0 228 156

**Fig. 9**

F/F — FLIP-FLOP;
I.B. — INPUT BUFFER OR THE INPUT PART OF THE BIDIRECTIONAL BUFFER;
O.B. — OUTPUT BUFFER ·
C.L. — COMBINATIONAL LOGIC;

TDI — TEST DATA IN;
TDO — TEST DATA OUT;
SDO — SERIAL DATA OUT;
SSM — SERIAL SHIFT MODE DISABLE;
LRFF — LAST RANK OF F/F's TO OUTPUT DISABLE;
NOP — NORMAL OPERATION SELECT.

0 228 156

**Fig. 10**

F/F — FLIP-FLOP;
I.B. — INPUT BUFFER OR THE INPUT PART OF THE BIDIRECTIONAL BUFFER;
O.B. — OUTPUT BUFFER;
C.L. — COMBINATIONAL LOGIC;

TDI — TEST DATA IN;
TDO — TEST DATA OUT;
SDO — SERIAL DATA OUT;
SSM — SERIAL SHIFT MODE DISABLE;
LRFF — LAST RANK OF F/F's TO OUTPUT DISABLE;
NOP — NORMAL OPERATION SELECT.

OCMS REGISTERS

CONTROL REG.  INPUT REGISTER  OUTPUT REGISTER  2:1  TDO

0 228 156

Fig. 11

F/F — FLIP-FLOP;
I.B. — INPUT BUFFER OR THE INPUT PART
OF THE BIDIRECTIONAL BUFFER;
O.B. — OUTPUT BUFFER;
C.L. — COMBINATIONAL LOGIC;

TDI — TEST DATA IN;
TDO — TEST DATA OUT;
SDO — SERIAL DATA OUT;
SSM — SERIAL SHIFT MODE DISABLE;
LRFF — LAST RANK OF F/F's TO OUTPUT DISABLE;
NOP — NORMAL OPERATION SELECT.

OCMS REGISTERS

Fig. 12

F/F — FLIP-FLOP;
I.B. — INPUT BUFFER OR THE INPUT PART OF THE BIDIRECTIONAL BUFFER;
O.B. — OUTPUT BUFFER;
C.L. — COMBINATIONAL LOGIC;

TDI — TEST DATA IN;
TDO — TEST DATA OUT;
SDO — SERIAL DATA OUT;
SSM — SERIAL SHIFT MODE DISABLE;
LRFF — LAST RANK OF F/Fs TO OUTPUT DISABLE;
NOP — NORMAL OPERATION SELECT.

0 228 156

Fig. 13

F/F — FLIP-FLOP;
I.B. — INPUT BUFFER OR THE INPUT PART
       OF THE BIDIRECTIONAL BUFFER;
O.B. — OUTPUT BUFFER;
C.L. — COMBINATIONAL LOGIC;

TDI — TEST DATA IN;
TDO — TEST DATA OUT;
SDO — SERIAL DATA OUT;
SSM — SERIAL SHIFT MODE DISABLE;
LRFF— LAST RANK OF F/F's TO OUTPUT DISABLE;
NOP — NORMAL OPERATION SELECT.

0 228 156

Fig. 14a

| NOP | CLOCK | DATA IN | TEST IN | OUT |
|-----|-------|---------|---------|-----|
| X | — | X | X | Q |
| I | ⌐_ | I | X | I |
| I | ⌐_ | O | X | O |
| O | ⌐_ | X | I | I |
| O | ⌐_ | X | O | O |

Fig. 14b

*Fig. 15a*

| NOP | CLK EN | CLOCK | DATA IN | TEST IN | OUT |
|---|---|---|---|---|---|
| X | X | — | X | X | Q |
| I | O | ⌐ | X | X | Q |
| I | I | ⌐ | I | X | I |
| I | I | ⌐ | O | X | O |
| O | X | ⌐ | X | I | I |
| O | X | ⌐ | X | O | O |

*Fig. 15b*

Fig. 16a

| NOP | SET | RESET | CLK EN | CLK | DATA IN | TEST IN | OUT |
|-----|-----|-------|--------|-----|---------|---------|-----|
| X | X | X | X | — | X | X | Q |
| I | I | O | X | ⌐ | X | X | I |
| I | X | I | X | ⌐ | X | X | O |
| I | O | O | I | ⌐ | I | X | I |
| I | O | O | I | ⌐ | O | X | O |
| O | X | X | X | ⌐ | X | I | I |
| O | X | X | X | ⌐ | X | O | O |

Fig. 16b